(19) Europäisches Patentamt
European Patent Office
Office européen des brevets

(11) EP 4 715 411 A2

(12) **EUROPEAN PATENT APPLICATION**

(43) Date of publication:
**25.03.2026 Bulletin 2026/13**

(21) Application number: **25196644.6**

(22) Date of filing: **19.08.2025**

(51) International Patent Classification (IPC):
**G01R 33/00** (2006.01)    **G01R 33/09** (2006.01)

(52) Cooperative Patent Classification (CPC):
**G01R 33/0029; G01R 33/09**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **23.09.2024 US 202418892933**

(71) Applicant: **Allegro MicroSystems, LLC
Manchester, NH 03103-3353 (US)**

(72) Inventor: **DRINOVSKY, Martin
25262 Horomerice (CZ)**

(74) Representative: **South, Nicholas Geoffrey et al
Venner Shipley LLP
200 Aldersgate
London EC1A 4HD (GB)**

(54) **SENSOR HAVING TRANSLINEAR LINEARITY COMPENSATION**

(57)    Method and apparatus for a magnetic sensor device having a magnetic field sensing element to generate an output signal and a signal processing module coupled to the magnetic field sensing element, the signal processing module including linearization module having an analog translinear circuit.

**FIG. 1**

**Description**

BACKGROUND

Magnetic sensors are widely used in modern systems to measure or detect physical parameters such as magnetic field strength, current, position, motion, orientation, and so forth. There are many different types of sensors for measuring magnetic fields and other parameters. However, such sensors suffer from various limitations, for example, excessive size, inadequate sensitivity and/or dynamic range, cost, reliability, linearity and the like. One known technique to address sensor linearization is disclosed in U.S. Patent No. 9,245,547, which is incorporated herein by reference.

SUMMARY

Example embodiments of the disclosure provide methods and apparatus for a magnetoresistive sensor having analog linearity compensation using a translinear circuit. In embodiments, the translinear circuit includes a programmable coefficient for achieving desired compensation characteristics. In example embodiments, two-quadrant compensation includes a one-quadrant nonlinear circuit and at least one signal polarity switch.

In one aspect, a magnetic sensor device comprises: a magnetic field sensing element to generate an output signal; a signal processing module coupled to the magnetic field sensing element, the signal processing module including a linearization circuit having an analog translinear circuit for linearizing the output signal generated by the magnetic field sensing element; and an output module to receive the linearized signal from the linearization module and provide a device output signal.

A device can further include one or more of the following features: the magnetic field sensing element comprises a magnetoresitive (MR) element, the translinear circuit comprises a cube circuit, the cube circuit comprises a single quadrant cube circuit, the linearization module includes first and second polarity switches, wherein the first polarity switch is coupled to an input of the translinear circuit and the second polarity switch is coupled to an output of the translinear circuit, the translinear circuit comprises a loop of transistors, the transistors comprise bipolar transistors, the transistors comprise MOS transistors configured in weak inversion, a current reference coupled to the translinear circuit for setting a level of linearization of the output signal, the reference current generates a bias current that is programmable to control the level of linearization of the output signal, and/or the linearization module includes a programmable mirroring factor M for controlling the level of linearization of the output signal.

In another aspect a method comprises: employing a magnetic field sensing element, which forms part of a magnetic sensor device, to generate an output signal; employing a signal processing module coupled to the magnetic field sensing element, the signal processing module including a linearization circuit having an analog translinear circuit for linearizing the output signal generated by the magnetic field sensing element; and employing an output module to receive the linearized signal from the linearization module and provide a device output signal.

A method can further include one or more of the following features: the magnetic field sensing element comprises a magnetoresitive (MR) element, the translinear circuit comprises a cube circuit, the cube circuit comprises a single quadrant cube circuit, the linearization module includes first and second polarity switches, wherein the first polarity switch is coupled to an input of the translinear circuit and the second polarity switch is coupled to an output of the translinear circuit, the translinear circuit comprises a loop of transistors, the transistors comprise bipolar transistors, the transistors comprise MOS transistors configured in weak inversion, a current reference coupled to the translinear circuit for setting a level of linearization of the output signal, the reference current generates a bias current that is programmable to control the level of linearization of the output signal, and/or the linearization module includes a programmable mirroring factor M for controlling the level of linearization of the output signal.

BRIEF DESCRIPTION OF THE DRAWINGS

The foregoing features of this disclosure, as well as the disclosure itself, may be more fully understood from the following description of the drawings in which:

FIG. 1 is a block diagram of a sensor having analog translinear linearity compensation;

FIG. 1A is a block diagram of a sensor having magnetoresistive (MR) sensing elements coupled in a bridge for which analog translinear linearity compensation is performed;

FIG. 2A is a diagram of an illustrative GMR stack for example MR sensing elements;

FIG. 2B shows MR element magnetic orientation behavior for low resistance, linear region, and high resistance in response to an applied field;

FIG. 3 is a high level block diagram of an example analog translinear linearity compensation module for a sensor;

FIG. 4 is a schematic representation of an example implementation of the analog translinear linearity compensation module of FIG. 3;

FIG. 5 is a schematic representation of an example transistor-level implementation of the analog translinear linearity compensation module of FIG. 4; and

FIG. 6 is a graphical representation of linearity compensation achieved by the circuit of FIG. 5 as compared to a sensor without linearity compensation.

DETAILED DESCRIPTION

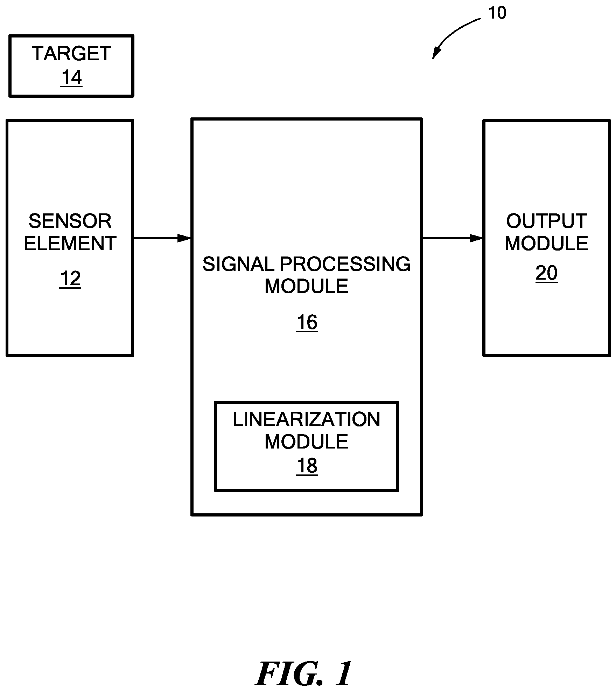

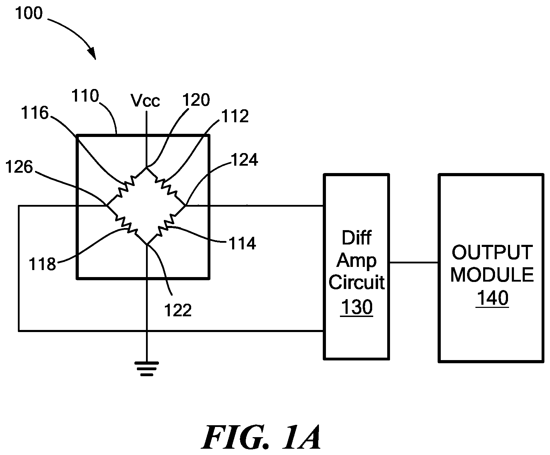

FIG. 1 is a circuit diagram illustrating an example of a magnetic field sensor 10 including a magnetic field sensing element 12 having enhanced linearity compensation in accordance with illustrative embodiments of the disclosure. The magnetic field sensing element 12 senses a target 14, such as a ferromagnetic gear tooth, that causes changes in a magnetic field. A signal processing module 16 is coupled to the magnetic field sensing element 12 to process the signal from the sensing element. In an illustrative embodiment, the signal processing module 16 includes a linearization module 18 to enhance the linearity of the signal from the sensor element 12, as described more fully below. An output module 20 is coupled to the signal processing module 16 to provide an output signal for a device containing the magnetic field sensor.
While an example embodiment of the disclosure is shown as a magnetic field position sensor using MR sensing elements, it is understood that embodiments of the invention can be provided as any type of sensor in which linearity is desirable, such as current sensors.
In one embodiment shown in FIG. 1A, the magnetic field sensing element 12 of FIG. 1 is provided as a magnetoresistive (MR) element 110, such as GMR or TMR elements, in the form of a Wheatstone bridge as part of a magnetic field sensor 100. The Wheatstone bridge circuit 110 includes magnetic field sensing elements, such as MR elements 112, 114, 116, 118, disposed on the respective branches of the bridge 110.
In the illustrative embodiment, one end of the MR element 112 and one end of the MR element 116 are connected in common to a power supply terminal $V_{cc}$ via a node 120, one end of the MR element 114 and one end of the MR element 118 are connected in common to ground via a node 122. The other end of the MR element 112 and the other end of the MR element 114 are connected to a node 124, and the other end of the MR element 116 and the other end of the MR element 118 are connected to a node 126.
Node 124 of the Wheatstone bridge circuit 110 is connected to a differential amplifier circuit 130. Node 126 is also connected to the differential amplifier circuit 130. A first output of the differential amplifier circuit 130 is connected to an output module 140. In embodiments, Vcc can be used to compensate for gain changes of the MR elements over process and temperature. It is understood that the differential amplifier circuit 130 can include offset trim to correct for MR sensor mismatch.
The magnetic field sensing planes of the MR elements 112, 116 and 114, 118 react to changes in a magnetic field by corresponding resistances changes. MR elements 112, 118 have maximum and minimum resistances at locations opposite in phase to that of MR elements 114, 116. This is due to either how the magnetics of the system are set up or different pinning orientations of the elements. As a result, the voltages at the nodes 124, 126 (mid-point voltages) of the Wheatstone bridge circuit 110 also change in a similar fashion.
Magnetoresistance refers to the dependence of the electrical resistance of a sample on the strength of external magnetic field characterized as:

$$\delta_H = \frac{R(0) - R(H)}{R(H)},$$

where R(H) is the resistance of the sample in a magnetic field H, and R(0) corresponds to H = 0. The term "giant magnetoresistance" indicates that the value $\delta_H$ for multilayer structures significantly exceeds the anisotropic magnetoresistance, which has a typical value within a few percent.
Giant magnetoresistance (GMR) is a quantum mechanical magnetoresistance effect observed in thin-film structures composed of alternating ferromagnetic and nonmagnetic conductive layers. The effect is observed as a significant change in the electrical resistance depending on whether the magnetization of adjacent ferromagnetic layers are in a parallel or an antiparallel alignment. The overall resistance is relatively low for parallel alignment and relatively high for antiparallel alignment. The magnetization direction can be controlled, for example, by applying an external magnetic field. The effect is based on the dependence of electron scattering on the spin orientation. A Wheatstone bridge of four identical GMR devices is insensitive to a uniform magnetic field and is reactive when the field directions are antiparallel in the neighboring arms of the bridge.

Another type of MR elements include Tunneling Magnetoresistive (TMR) elements based on a magnetic tunnel junction (TMJ) that includes ferromagnetic separated by a thin insulative barrier layer. Electrons tunnel through the barrier in a quantum mechanical phenomenon. It may be desirable to provide analog translinear linearity compensation for TMR sensing elements in example embodiments of the disclosure.

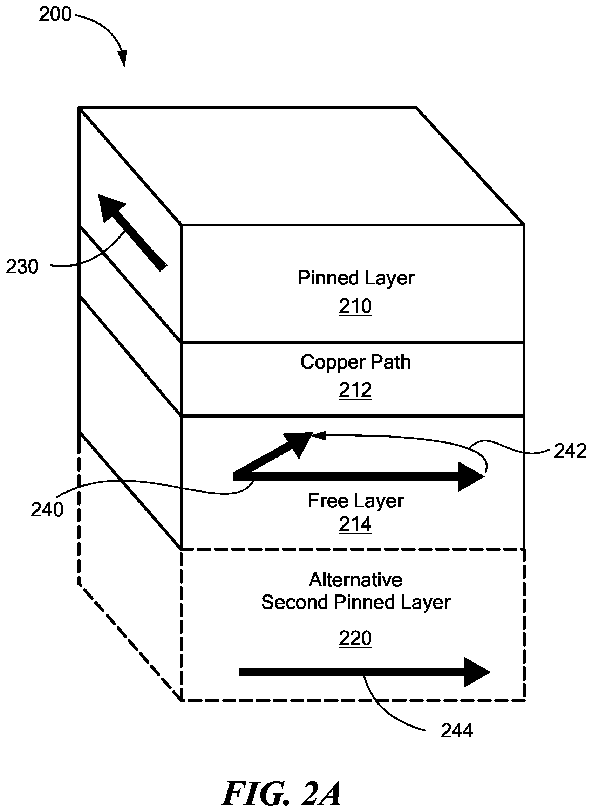

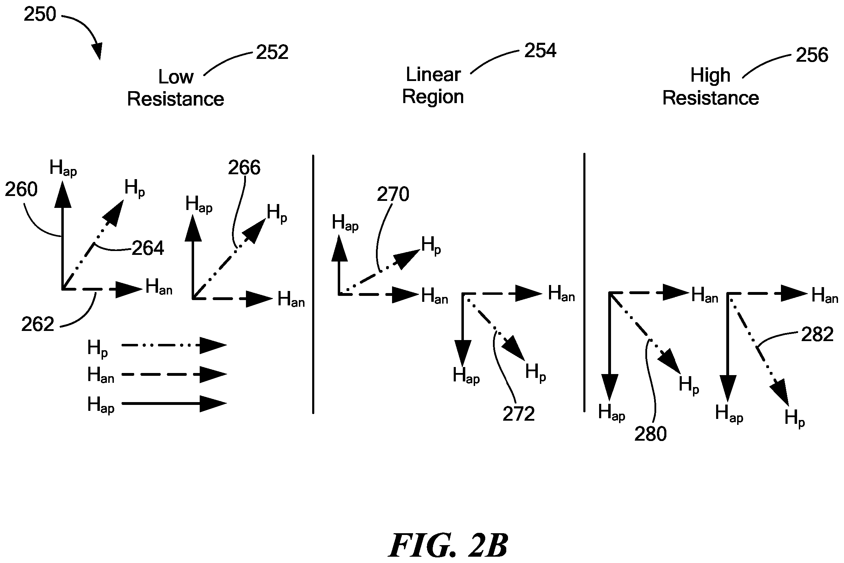

FIGs. 2A and 2B illustrate a simplified GMR sensor 200 that can form a part of the magnetic field sensor 10 of FIG. 1 according to an embodiment. In FIG. 2A, the GMR sensor 200 includes a pinned layer 210, a metal path 212, such as copper, and a free layer 214. The magnetic orientation of the pinned layer 210 is fixed. The magnetic orientation of the free layer 214 is maintained in a selected alignment through anisotropy or by the shown alternative second pinned layer 220, each of which provide a pinning field, $H_{an}$ 242 (FIG. 2B). The magnetic orientation of the free layer 214 rotates 242 based on the applied field.

As shown, anisotropy may be used to creates a 90° zero applied field orientation 240 of the free layer 220, or a 90° zero applied field orientation 240 may be provided with the second pinned layer 220, which is 90° to the pinned layer.

FIG. 2B shows vector diagrams 250 of orientations of the free layer due to different applied fields: a low resistance region 252, a linear region 254 and a high resistance region 256. As shown in the low resistance region 252, an applied field 260 and a field with a strength of $H_{an}$ at 90° to the pinned layer 210 generate $H_p$ 264. The applied field 260 sums with pinning field $H_{an}$ 262 to determine the direction 264 of the free layer. As the direction 264 of the free layer changes, the resistance of the GMR sensor also changes. The directions $H_p$ of the free layer 270, 272, 280, 282 in the linear region 254 and the high resistance region 256 are also shown using vector diagrams.

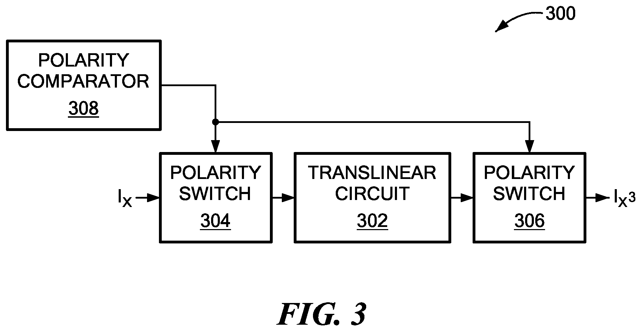

FIG. 3 shows a portion 300 of an example sensor having an analog translinear circuit 302 for enhancing the linearity of signals from magnetic sensing elements, for example. In the illustrated embodiment, input and output polarity switches 304, 306 are used since the translinear circuit 302 may not be differential. A polarity comparator 308 can control the polarity switches, as described more fully below.

In embodiments, the translinear circuit 302 comprises a translinear cubing circuit which operates only in one quadrant to compensate for third order effects in MR sensing elements. To support two quadrant operation, since the input signal can be positive and negative, there are polarity switches 304,306 on the input and output of the translinear circuit 303 which are controlled by the polarity comparator 308.

It is known that certain magnetic sensors, such as TMR and GMR based sensors may have significant nonlinearity issues. MR-based sensors generally have elements configured in bridge configurations that mostly cancel second order nonlinearity. Embodiments of the disclosure provide an analog translinear circuit to correct for third order nonlinearity.

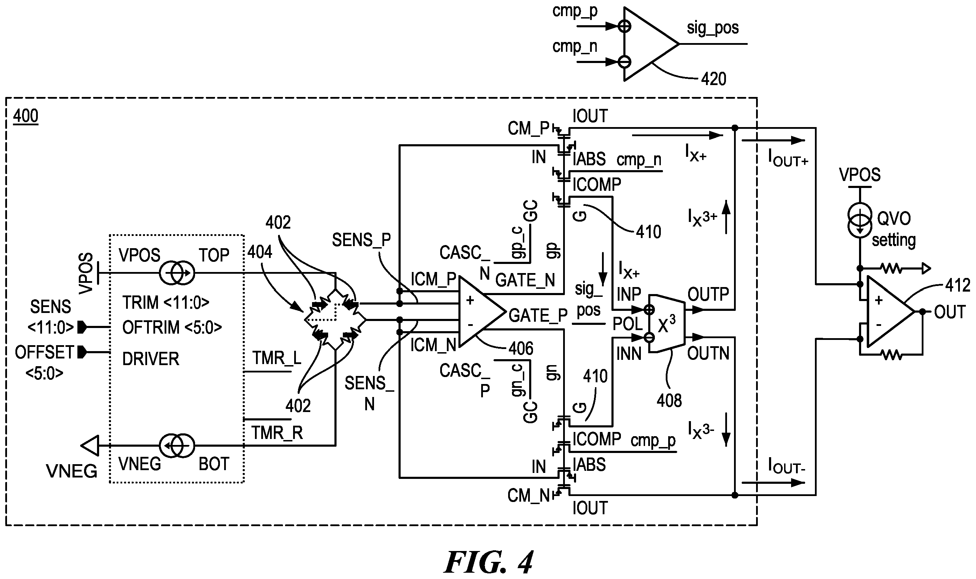

FIG. 4 shows an example implementation of a sensor having analog circuitry 400 for enhancing the linearity of signals from magnetic sensing elements 402. A bridge 404 which is formed from GMR or TMR elements 402, for example, provides differential inputs to an amplifier 406. Outputs of the differential amplifier 406 are coupled to a translinear circuit 408 for linearizing the signals from the MR sensing elements. In the illustrated embodiment, a series of current mirrors 410 are used at the amplifier 406 outputs to provide copies of the output signals to other places in the circuit, as shown and as described more fully below. The output of the translinear circuit 408 can be coupled to a backend amplifier 412 in a manner well known in the art.

The circuit amplifies and processes current from the bridge 404. In the illustrated embodiment, the operational amplifier 406 maintains a virtual zero at the differential output of the bridge 404. The current needed for the amplifier to maintain the virtual zero (i.e., the signal current) is copied using the current mirrors 410 to the output, the linearity compensation circuit 408, and the polarity comparator 420.

In an alternative embodiment, the circuit can be operated using a resistance mode of the MR bridge 404. In this mode, the output of the MR bridge 404 is a differential voltage. A voltage to current converter can convert the bridge voltage signal to a current level for processing by the linearity compensation circuit 408.

In the illustrated embodiment, the linearity compensation circuit 408 takes the transducer signal current $I_{x+/-}$ (or a scaled copy) as the input from the amplifier 406 and generates a scaled third order output $I_{x3+}$ and $I_{x3-}$. The scaling factor, which can be referred to as "C," can be positive or negative based on the type of the nonlinearity. In some embodiments, the scaling factor can be made programmable to match the particular MR bridge nonlinearity and/or compensate for its variation over PVT, as described more fully below.

To obtain the final compensated signal, the output current from the front-end amplifier 406 and the linearity compensation circuit 308 is combined by summing the respective output currents:

$$I_{\mathrm{OUT}} = I_X + I_{X3+} = I_X + C \cdot I_X^3$$

Since the linearity compensation operates only in one quadrant, the polarity comparator 420 can be used to sense the polarity of the input signal and feed this digital signal to the linearity compensation circuit 408. An output of the polarity comparator 420 is provided as an input to the translinear circuit 408, and more particularly to polarity switches.

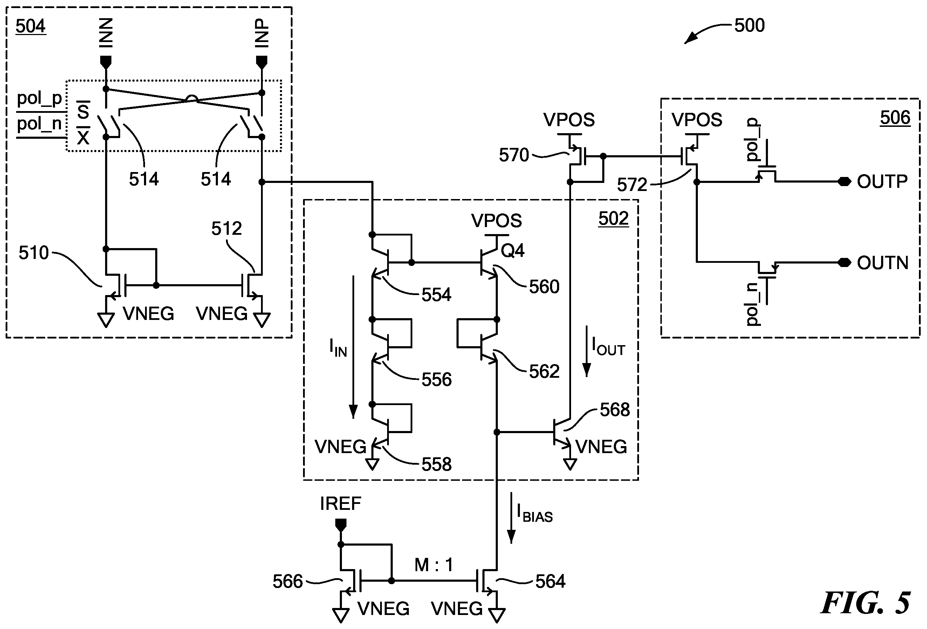

FIG. 5 shows a transistor-level circuit implementation 500 of an analog translinear circuit 502 providing linearity compensation coupled to input 504 and output 506 polarity switches. The input polarity switch 504 receives the input differential signals INP, INN from an amplifier, such as the amplifier 406 in FIG. 4, and provides a single-ended signal to the translinear circuit 502 having a polarity defined by the differential inputs. In the illustrated embodiment, first and second transistors 510, 512 are coupled in a mirror configuration as shown, to switches 514 controlled by polarity signals pol_p, pol_n from a polarity comparator (e.g., 420 FIG. 4) for providing the output signal to the translinear circuit 502. As can be seen, polarity inversion is achieved by switching the differential inputs. The output polarity switch 506 switches single ended output current from the translinear circuit 502 to either a positive or negative differential output based on a signal from the polarity comparator.

The translinear circuit 502, which is a cubing circuit in the illustrated embodiment, includes a loop of transistors, shown as bipolar transistors (BJTs). In other embodiments, MOS transistors biased in weak inversion can be used. In the illustrated embodiment, the input signal $I_{IN}$ to the translinear circuit is connected to three transistors 554, 556, 558 are coupled end-to-end. Fourth and fifth transistors 560, 562 are coupled end-to-end with the fourth transistor 560 mirrored with the third transistor 554. A bias current $I_{BIAS}$ flows through the fourth and fifth transistors 560, 562 and out of the translinear circuit to a seventh transistor 564, which is mirrored to an eighth transistor 566 with a mirror scaling factor or M: 1, as discussed more fully below. A ninth transistor 568, which has a gate coupled to the bias current $I_{BIAS}$, is connected to an output transistor 570, which is mirrored with a transistor 572 in the output polarity switch 506.

According to translinear principle, $I_{\mathrm{out}} = \frac{I_{\mathrm{in}}^3}{I_{\mathrm{bias}}^2} = \frac{I_{\mathrm{in}}^3}{I_{\mathrm{ref}}^2} M^2$ the product of BJT currents in one direction, e.g., clockwise (CW) is equal to product of BJT currents in another direction, e.g., counter clockwise (CCW), as shown below:

$$\prod_i I_i^{CW} = \prod_j I_j^{CCW}$$

In the illustrated embodiment, the product of BJT currents is:

$$I_{\mathrm{in}}^3 = I_{\mathrm{bias}}^2 I_{\mathrm{out}}$$

The bias current $I_{BIAS}$ may be derived from an on-chip current reference and is programmable to be able to set the desired "strength" of the linearity compensation. In one embodiment, programmability is implemented by the current mirror 566 with a programmable mirroring factor M. The equation for the output current $I_{OUT}$ is then:

$$I_{\mathrm{out}} = \frac{I_{\mathrm{in}}^3}{I_{\mathrm{bias}}^2} = \frac{I_{\mathrm{in}}^3}{I_{\mathrm{ref}}^2} M^2$$

With this arrangement, the output current $I_{OUT}$ has been linearized to compensation for non-linearity in the MR sensing elements. In example embodiments, third order effects have been compensated for. In other embodiments, additional non-linearity effects can be compensated for.

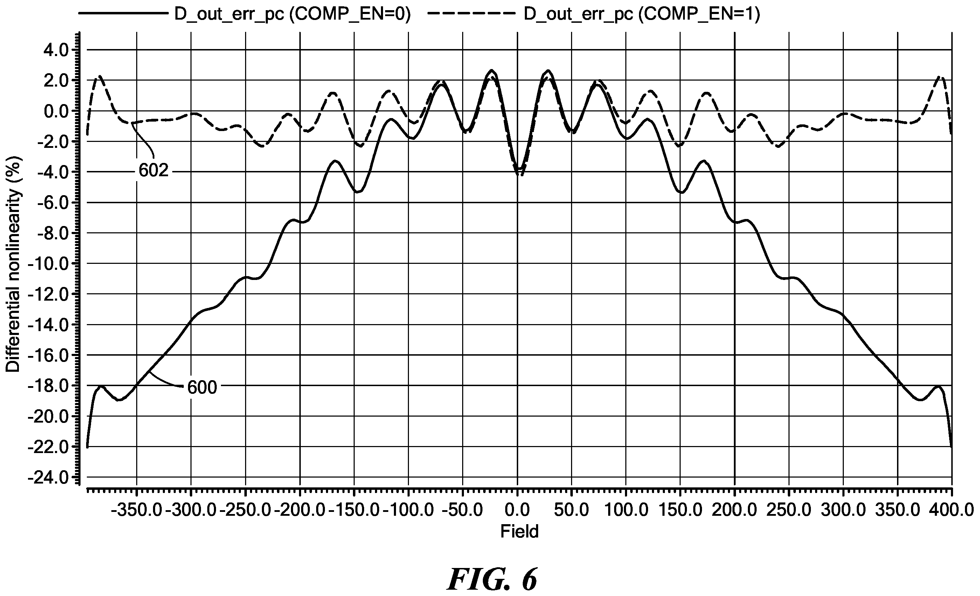

FIG. 6 shows example waveforms for a first signal 600 without linearity compensation and a second signal 602 with linearity compensation, such as by the translinear compensation circuit of FIG. 5. As can be seen the uncompensated signal 600 has significant non-linearity over the illustrated field of +/- 350 G. The linearity of the compensated signal 602 is significantly improved as compared to the uncompensated signal 600.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

Having described exemplary embodiments of the invention, it will now become apparent to one of ordinary skill in the art that other embodiments incorporating their concepts may also be used. The embodiments contained herein should not be limited to disclosed embodiments but rather should be limited only by the spirit and scope of the appended claims. All publications and references cited herein are expressly incorporated herein by reference in their entirety.

**Claims**

1. A magnetic sensor device, comprising:

   a magnetic field sensing element to generate an output signal;
   a signal processing module coupled to the magnetic field sensing element, the signal processing module including a linearization circuit having an analog translinear circuit for linearizing the output signal generated by the magnetic field sensing element; and
   an output module to receive the linearized signal from the linearization module and provide a device output signal.

2. The device according to claim 1, wherein the translinear circuit comprises a single quadrant cube circuit.

3. The device according to claim 1, further including a current reference coupled to the translinear circuit for setting a level of linearization of the output signal.

4. The device according to claim 3, wherein the reference current generates a bias current that is programmable to control the level of linearization of the output signal.

5. A method, comprising:

   employing a magnetic field sensing element, which forms part of a magnetic sensor device, to generate an output signal;
   employing a signal processing module coupled to the magnetic field sensing element, the signal processing module including a linearization circuit having an analog translinear circuit for linearizing the output signal generated by the magnetic field sensing element; and
   employing an output module to receive the linearized signal from the linearization module and provide a device output signal.

6. The method according to claim 5, or the device according to claim 1, wherein the magnetic field sensing element comprises a magnetoresitive (MR) element.

7. The method according to claim 5, or the device according to claim 1, wherein the translinear circuit comprises a cube circuit.

8. The method according to claim 5, wherein the translinear circuit comprises a single quadrant cube circuit.

9. The method according to claim 8, or the device according to claim 2, wherein the linearization module includes first and second polarity switches, wherein the first polarity switch is coupled to an input of the translinear circuit and the second polarity switch is coupled to an output of the translinear circuit.

10. The method according to claim 5, or the device according to claim 1, wherein the translinear circuit comprises a loop of transistors.

11. The method according to claim 5, or the device according to claim 1, wherein the translinear circuit comprises a loop of bipolar transistors.

12. The method according to claim 5, or the device according to claim 1, wherein the translinear circuit comprises a loop of MOS transistors configured in weak inversion.

13. The method according to claim 5, further including a current reference coupled to the translinear circuit for setting a level of linearization of the output signal.

**14.** The method according to claim 13, wherein the reference current generates a bias current that is programmable to control the level of linearization of the output signal.

**15.** The method according to claim 14, or the device according to claim 4, wherein the linearization module includes a programmable mirroring factor M for controlling the level of linearization of the output signal.

**FIG. 1**

FIG. 1A

200

230

Pinned Layer
210

Copper Path
212

240

Free Layer
214

242

Alternative
Second Pinned Layer
220

244

*FIG. 2A*

**FIG. 2B**

300

POLARITY
COMPARATOR
308

$I_x$ → POLARITY SWITCH 304 → TRANSLINEAR CIRCUIT 302 → POLARITY SWITCH 306 → $I_x{}^3$

## FIG. 3

**FIG. 4**

EP 4 715 411 A2

FIG. 5

EP 4 715 411 A2

14

**FIG. 6**

EP 4 715 411 A2

**REFERENCES CITED IN THE DESCRIPTION**

**Patent documents cited in the description**

- US 9245547 B